# EUROPEAN PATENT APPLICATION

(11) **EP 4 773 765 A1**
(43) Date of publication of application: **08.07.2026**
(21) Application number: 24868314.6
(22) Date of filing: 19.09.2024
(51) Int. Cl.: H10K 30/50, H10K 30/40, H10K 30/86, H10K 71/12, H10K 85/50

(54) **PEROVSKITE PRECURSOR SOLUTION, METHOD FOR MANUFACTURING SOLAR CELL, AND SOLAR CELL**

(30) Priority: 21.09.2023 JP 2023156424
(71) Applicant: KANEKA CORPORATION, Osaka 530-8288 (JP)
(72) Inventor: MISHIMA Ryota, Settsu-shi, Osaka 566-0072 (JP); FURUMAKI Shu, Settsu-shi, Osaka 566-0072 (JP); OKAMOTO Shimpei, Settsu-shi, Osaka 566-0072 (JP); ISHIBASHI Hirotaka, Settsu-shi, Osaka 566-0072 (JP)
(74) Representative: Hoffmann Eitle
(86) International application number: PCT/JP2024/033461
(87) International publication number: WO 2025/063237

(57) **Abstract**

The present invention provides a perovskite precursor solution which is capable of simultaneously forming a hole transport layer and a photoelectric conversion layer without forming a layer that inhibits transmission of electrons. A perovskite precursor solution according to one aspect of the present invention includes: a solvent; a perovskite precursor which forms a perovskite compound that performs photoelectric conversion; a hole transport layer forming compound which forms a self-assembled monolayer that has hole-selective permeability; and a fluorine-containing organic compound.

## Description

### TECHNICAL FIELD

The present invention relates to a perovskite precursor solution, a method for producing a solar cell, and a solar cell.

### BACKGROUND ART

Solar cells have been widely used as an energy source with a small environmental load. As one type of the solar cells, a perovskite solar cell having a photoelectric conversion layer mainly composed of a perovskite compound is known. A basic perovskite solar cell is formed by laminating a first electrode layer, a first charge transport layer, a perovskite photoelectric conversion layer, a second charge transport layer, and a second electrode layer in this order on a substrate. In addition, since the perovskite solar cell has an absorption wavelength different from that of a solar cell in which a crystalline silicon substrate is used as the photoelectric conversion layer, the perovskite solar cell also can be used by laminating on a crystalline silicon solar cell. The charge transport layer is a layer that selectively allows electrons or holes to pass therethrough and is also an electric resistance that causes internal loss. Therefore, to reduce the electric resistance, a technique of forming a charge transport layer having a small thickness by a self-assembled monolayer composed of a carbazole compound having a charge selection function has also been proposed (for example, see Patent Document 1).

In general, to form a self-assembled monolayer, it is required to thinly and uniformly apply a material solution by spin coating or the like. When increasing the size of a solar cell, it is difficult to employ spin coating, and coating is desirably performed by a method such as die coating or bar coating. In addition, since the perovskite photoelectric conversion layer is also generally formed by coating, if the first charge transport layer is formed by coating, coating and drying needs to be repeatedly performed. It has been reported that in order to efficiently produce a solar cell, a carbazole compound that forms a hole-selective self-assembled monolayer is blended into a perovskite precursor solution and the resulting solution is applied, whereby the carbazole compound forms a self-assembled monolayer at the interface with an electrode layer of the resulting coating film, and a hole transport layer and a perovskite photoelectric conversion layer can be simultaneously formed (for example, see Non-Patent Document 1).

### Citation List

### Patent Documents

Patent Document 1: Japanese Unexamined Patent Application, Publication No. 2023-46212

### Non-Patent Documents

Non-Patent Document 1: "Co-deposition of hole-selective contact and absorber for improving the processability of perovskite solar cells" Nature Energy, 2023, vol. 8, pp.462-472

### DISCLOSURE OF THE INVENTION

### Problems to be Solved by the Invention

When the carbazole compound is blended into the perovskite precursor solution as in Non-Patent Document 1, it is necessary to blend the carbazole compound in excess with respect to the coating area to form a hole transport layer having no gaps. As a result of verification by the present inventors, it was confirmed that the excessive amount of the carbazole compound in the precursor solution can form a layer on the surface of the coating film and can inhibit the transfer of electrons.

An object of the present invention is to provide a perovskite precursor solution capable of simultaneously forming a hole transport layer and a photoelectric conversion layer without forming a layer that inhibits electron transmission, a method for producing a solar cell, and a solar cell that can be easily produced.

### Means for Solving the Problems

A perovskite precursor solution according to one aspect of the present invention includes a solvent; a perovskite precursor that forms a perovskite compound to perform photoelectric conversion; a hole transport layer-forming compound that forms a self-assembled monolayer having hole selective permeability; and a fluorine-containing organic compound.

In the perovskite precursor solution described above, the fluorine-containing organic compound may have at least one or more of an amino group, a hydrazine group, a trialkylamino group, a phosphocholine group, a phosphoric acid group, a phosphonic acid group, a hydroxy group, a carboxy group, a sulfonyl group, or ionized products thereof, at a terminal of the fluorine-containing organic compound.

In the perovskite precursor solution, the fluorine-containing organic compound may have a carbon skeleton containing an alkyl chain or benzene in which hydrogen is substituted with fluorine or a trifluoromethyl group.

In the perovskite precursor solution described above, the alkyl chain or the benzene may continuously include carbon to which fluorine is bonded.

In the perovskite precursor solution described above, the fluorine-containing organic compound may have a terminal group that can be cationized and a terminal group that can be anionized.

The perovskite precursor solution may contain a plurality of types of the fluorine-containing organic compounds.

In the perovskite precursor solution described above, the perovskite precursor may include a metal halide including a lead halide and may include a halogenated organic compound or a halogenated alkali metal. The molar concentration of the metal may be in excess of 0.5 mol% or more and 10 mol% or less with respect to the sum of the molar concentration of the organic compound and the molar concentration of the alkali metal.

The perovskite precursor solution described above may further include a hydrochloride that promotes crystal growth of the perovskite compound.

A method for producing a solar cell according to one aspect of the present invention includes the steps of: coating a first electrode layer formed on one main surface of a substrate with a perovskite precursor solution; and volatilizing a solvent from a coating film of the perovskite precursor solution and allowing the perovskite precursor to react and produce crystals of the perovskite compound.

A solar cell according to one aspect of the present invention includes: a plate-shaped or sheet-shaped substrate; a first electrode layer laminated on one main surface of the substrate; a hole transport layer laminated on the first electrode layer, the hole transport layer including a film of a hole transport layer-forming compound that has hole selective permeability; a photoelectric conversion layer laminated on the hole transport layer, the photoelectric conversion layer including a perovskite compound; an excess material layer partially laminated on the photoelectric conversion layer, the excess material layer including the hole transport layer-forming compound; a passivation layer laminated on a region in the photoelectric conversion layer where the excess material layer is absent, the passivation layer including a fluorine-containing organic compound and; a second electrode layer laminated on the excess material layer and the passivation layer.

In the above-described method for producing a solar cell, the photoelectric conversion layer may have an impurity film containing a halide of a metal atom included in the perovskite compound, at a grain boundary of a crystal of the perovskite compound. Effects of the Invention

According to the present invention, it is possible to provide a perovskite precursor solution capable of simultaneously forming a hole transport layer and a photoelectric conversion layer without forming a layer that inhibits electron transmission, a method for producing a solar cell, and a solar cell that can be easily produced.

### BRIEF DESCRIPTION OF THE DRAWINGS

[FIG. 1] FIG. 1 is a schematic cross-sectional view showing a configuration of a solar cell according to an embodiment of the present invention; and
[FIG. 2] FIG. 2 is a flowchart showing procedures of a method for producing a solar cell according to one embodiment of the present invention.

### PREFERRED MODE FOR CARRYING OUT THE INVENTION

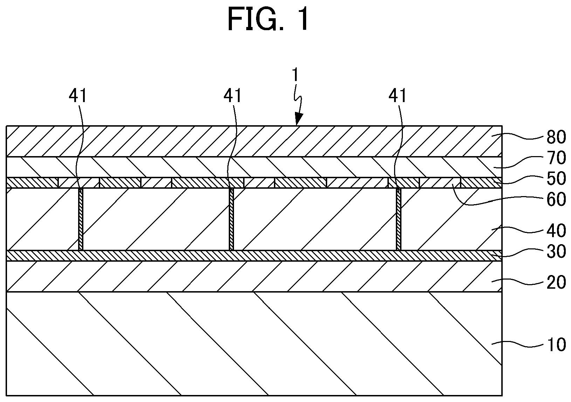

Hereinafter, embodiments of the present invention will be described with reference to the drawings. FIG. 1 is a schematic cross-sectional view showing a configuration of a solar cell 1 according to the embodiment of the present invention. The dimensions of various members in the drawings are adjusted for ease of viewing for convenience.

The solar cell 1 includes: a plate-shaped or sheet-shaped substrate 10; a first electrode layer 20 laminated on one main surface of the substrate 10 (lower side in FIG. 1); a hole transport layer 30 laminated on one surface of the first electrode layer 20; a photoelectric conversion layer 40 laminated on one surface of the hole transport layer 30; an excess material layer 50 partially laminated on one surface of the photoelectric conversion layer 40; a passivation layer 60 laminated in an absent region on the excess material layer 50 on one surface of the photoelectric conversion layer 40; an electron transport layer 70 laminated on each of one surface of the excess material layer 50 and one surface of the passivation layer 60; and a second electrode layer 80 laminated on the electron transport layer 70.

The substrate 10 is a structure that supports other layers and secures the strength of the solar cell 1. When the solar cell 1 receives light from a substrate 10 side, the substrate 10 is formed of a transparent material. Specifically, the substrate 10 may be formed of glass or a resin such as polyimide, polyamide, polyethylene terephthalate, and the like. When the solar cell 1 receives light from a second electrode layer 80 side, the substrate 10 may be formed of a composite material including a metal layer.

The first electrode layer 20 collects holes generated in the photoelectric conversion layer 40 through the hole transport layer 30 and outputs the collected holes to the outside. The first electrode layer 20 may be formed of a transparent conductive oxide (TCO) having conductivity and light transmittance. As the transparent conductive oxide that forms the first electrode layer 20, indium oxide, tin oxide, zinc oxide, titanium oxide, and composite oxides thereof may be used. Among these, an indium-based composite oxide that contains indium oxide, zinc oxide, tungsten oxide, molybdenum oxide, or the like as a main component, or a fluorine-doped tin oxide is preferable. From the viewpoint of high conductivity and transparency, indium oxide is particularly preferable. The first electrode layer 20 is preferably subjected to a surface treatment such as an ozone treatment to improve moldability of the hole transport layer 30 and may have, on the surface thereof, a multilayer structure having a p-type oxide semiconductor layer that contains nickel oxide, niobium oxide, or the like as a main component.

The hole transport layer 30 is formed of a film of a hole transport layer-forming compound that forms self-assembled monolayers (SAM). Among positive and negative optical carriers (holes and electrons) generated in the photoelectric conversion layer 40, the hole transport layer 30 transmits only holes to the first electrode layer 20. The hole transport layer-forming compound that forms the hole transport layer 30 preferably has a functional group capable of transporting holes, such as a carbazole-based, phenothiazine-based, or dimethylacridine-based functional group, and a self-assembling terminal group that chemically binds to a substrate, such as phosphoric acid or carboxylic acid. The hole transport layer-forming compound preferably has a straight chain material, such as an alkyl chain, between the functional group and the self-assembling terminal group, to have passivation property. The alkyl chain preferably has four or more carbon atoms. Specifically, examples of the hole transport layer-forming compound that forms the hole transport layer 30 include Me-4PACz ([4-(3,6-dimethyl-9H-carbazol-9-yl)butyl]phosphonic acid), MeO-4PACz ([4-(3,6-dimethoxy-9H-carbazol-9-yl)butyl ]phosphonic acid), Me-PhpPACz ([4-(3,6-dimethyl-9H-carbazol-9-yl)phenyl]phosphonic acid), and DMAcPA ((4-(2,7-dibromo-9,9-dimethylacridin-10(9H)-yl)butyl)phosphonic acid).

The photoelectric conversion layer 40 includes a perovskite compound that performs photoelectric conversion and generates light carriers by absorbing incident light. As the perovskite compound included in the photoelectric conversion layer 40, a compound represented by ABX₃ can be used, including an organic atom A including at least one of an alkali metal (Am), a monovalent organic ammonium ion, or an amidinium-based ion; a metal atom B that generates a divalent metal ion; and a halogen atom X including at least one of an iodide ion I, a bromide ion Br, a chloride ion Cl, or a fluoride ion F. Examples of the alkali metal at site-A include potassium K, cesium Cs, and rubidium Rb, and examples of the organic atom A include methylammonium MA (CH₃NH₃) and formamidinium FA (CH₃N₂). Examples of the metal atom B include lead Pb and tin Sn, and lead is preferably used as a main component. As the halogen atom X, at least one of iodide I, bromide Br, or chloride Cl is preferable.

Specifically, preferable examples of the perovskite compound include a methyl ammonium lead halide (MAPbX₃) such as MAPbI₃, MAPbBr₃, and MAPbCl₃, and a formamidinium lead halide (FAPbX₃) such as FAPbI₃, FAPbBr₃, and FAPbCl₃. Note that the halogen atom X may contain multiple types. The perovskite compound may be in the form of FA_{y}MA_{1-y}PbX₃, containing both methylammonium and formamidinium. When containing an alkali metal, Am_{y}FA_{z}MA_{1-y-z}PbX₃, Am_{y}FA_{1-y}PbX₃, and the like are exemplified. Am may be a single type or multiple types of Cs, Rb, and K. (y and z are any positive integers.) The halogen atom X may also include multiple types.

The photoelectric conversion layer 40 preferably has, in a grain boundary of a crystal of the perovskite compound, an impurity film 41 that contains a halide of a metal atom of the perovskite compound such as Pb, PbI₂, PbBr₂, or PbCl₂. To be able to form such an impurity film 41, the metal B in the perovskite compound is preferably lead Pb. When the photoelectric conversion layer 40 has the impurity film 41 containing metal atom B and a metal compound, it is possible to suppress the hole transport layer-forming compound, which forms the hole transport layer 30 when the photoelectric conversion layer 40 is formed, and the fluorine-containing organic compound, which forms the passivation layer 60, from being left in the grain boundary of the crystal of the perovskite compound, and to thereby improve photoelectric conversion efficiency.

The excess material layer 50 is formed of the same hole transport layer-forming compound as the compound that forms the hole transport layer 30. Since the hole transport layer-forming compound used as the hole transport layer 30 has the lowest unoccupied molecular orbital that is lower (close to a vacuum level) than a conduction band of the perovskite compound, electron transport is blocked, and electrons do not easily reach the electron transport layer and behave as a resistance. Ideally, it is preferable that the excess material layer 50 is not formed, but in the case where the hole transport layer 30 and the photoelectric conversion layer 40 are formed in the same process, it is necessary to blend a slightly larger amount of the hole transport layer-forming compound than necessary in order to form the hole transport layer 30 that covers the entire surface of the first electrode layer 20 without gaps. The excess amount of the hole transport layer-forming compound forms the excess material layer 50. Further, the excess material layer 50 can also function as an anchor to improve adhesion to the electron transport layer 70. That is, since the fluorine-containing organic compound, which generally has a low surface free energy, has poor adhesion to the electron transport layer 70, the drawback can be compensated by forming the excess material layer 50. The excess material layer 50 may consist of the hole transport layer-forming compound or may include other materials included in the perovskite precursor solution. The weight content of the hole transport layer-forming compound in the excess material layer 50 is preferably 10% or more, and more preferably 30% or more. The weight content of the hole transport layer-forming compound in the excess material layer 50 is preferably 90% or less, and more preferably 70% or less. That is, in the region where the passivation layer is not formed, the perovskite compound partially comes into direct contact with the electron transport layer 70, which enables electron transport. However, it is more preferable that the hole transport layer-forming compound is formed on the surface of the perovskite compound and returns electrons back into the perovskite compound layer, rather than a surface that contains numerous defects is formed. The weight content of the hole transport layer-forming compound in the excess material layer 50 can be calculated based on the composition of the excess material layer measured by a combination of transmission electron microscope observation and energy dispersive X-ray analysis.

The passivation layer 60 prevents recombination of photocarriers at the interface with the photoelectric conversion layer 40 and promotes the arrival of electrons at the electron transport layer 70. The passivation layer 60 is formed in a manner that the passivation layer 60 competes against the excess material layer 50 for the surface of the photoelectric conversion layer 40 and prevents the excess material layer 50 from covering the entire surface of the photoelectric conversion layer 40 to lower the photoelectric conversion efficiency. The passivation layer 60 is composed of a fluorine-containing organic compound and is likely to exhibit lyophobicity with respect to a solvent containing an aprotic polar solvent such as dimethylformamide (DMF), dimethyl sulfoxide (DMSO), N-methylpyrrolidone (NMP), γ-butyrolactan (GBL), or acetonitrile, which is a solvent used to form the photoelectric conversion layer 40 and therefore is preferentially deposited on the surface of the photoelectric conversion layer 40 as compared with the excess material layer 50. Further, it has fluorine, which is electron-withdrawing, and preferentially transports electrons.

The fluorine-containing organic compound preferably has a carbon skeleton that contains an alkyl chain or benzene and has a structure in which hydrogen is partially substituted with fluorine, a trifluoromethyl group, or the like. More preferably, the carbon skeleton continuously contains carbon to which fluorine is bonded. In the case where the fluorine-containing organic compound has a benzene skeleton, it is preferable that among the six hydrogen atoms of benzene, one of them is bonded to a lyophilic group serving as a terminal, and at least one of the remaining five hydrogens is substituted with fluorine or a trifluoromethyl group. As the number of substitutions by fluorine and trifluoromethyl groups increases, the lyophobicity increases, and the effect of selectively orienting towards the surface increases. Therefore, when substituted with fluorine, it is preferable to have a structure of pentafluorobenzene in which all hydrogens other than one hydrogen bonded to the terminal are substituted with fluorine. When the fluorine-containing organic compound has an alkyl chain skeleton, it is preferable that the tip is a trifluoromethyl group or a fluorine or is a phenyl group having a trifluoromethyl group, and the terminal is a lyophilic group. The tip having fluorine is oriented toward the electron transport layer side, and the terminal having a lyophilic group is oriented toward the perovskite surface side. The skeleton on the straight chain excluding the tip and the terminal preferably has 1 or more and 17 or less carbon atoms. More preferably, the number of carbon atoms is 5 or more and 16 or less. To promote the formation of the passivation layer 60 by self-assembly, the longer the alkyl chain, the more the orientation of the fluorine-containing organic compound improved and the more the passivation property improved, whereas the insulating property is increased and the conductivity is lowered. Therefore, by providing an alkyl chain having the upper limit or more, sufficient orientation can be provided, and by providing an alkyl chain having the lower limit or less, both the passivation property and conductivity can be achieved. When the fluorine-containing organic compound has an alkyl chain skeleton and the tip is a trifluoromethyl group, the alkyl chain extending from the tip preferably continuously contains fluorinated carbon atoms. More preferably, all the carbon atoms are fluorinated except for one or two carbon atoms adjacent to the terminal. Continuous fluorination increases the lyophobicity, precipitating the fluorine-containing organic compound more selectively on the surface. This can promote the formation of the passivation layer 60. As another example of the fluorine-containing organic compound having an alkyl chain skeleton, a polymer structure may be mentioned. Since partially fluorinated polymer structure contains a large amount of fluorine, the polymer structure tends to be oriented in a planar manner, unlike the case where the fluorine-containing tip is oriented toward the electron transport layer side and the lyophilic group-containing terminal is oriented toward the perovskite surface side. In the case where the fluorine-containing organic compound has an alkyl chain skeleton and the tip thereof is a phenyl group having fluorine or a trifluoromethyl group, the greater the number of fluorine or trifluoromethyl group substitutions, the greater the effect, as described above. Therefore, when hydrogen in the phenyl group is substituted with fluorine, pentafluorobenzene is preferable. Further, when both the phenyl group having fluorine and a trifluoromethyl group and the alkyl chain exist, deposition on the surface can be promoted more selectively than in the case of the fluorine-containing compound only having a benzene skeleton. The fluorine-containing organic compound preferably has a lyophilic group, specifically, at least one or more of an amino group, a hydrazine group, a trialkylamino group, a phosphoric acid group, a phosphonic acid group, a hydroxy group, a carboxy group, a sulfonyl group, or ionized products thereof, at its terminal. These are lyophilic with respect to an aprotic polar solvent, which is a solvent for forming the photoelectric conversion layer 40, and can be positioned on the surface of the photoelectric conversion layer 40 from a stage before a drying step by combining them with a skeleton that contains fluorine, which is lyophobic. The presence of a linear skeleton or a lyophilic group, or both enables molecules of the fluorine-containing organic compound to align efficiently, facilitating the formation of thin and uniform films. Consequently, this alignment contributes to a reduction in series resistance. When ionized, these terminals address surface defects on the perovskite layer-including iodine, lead, and halogen defects, which results in enhanced performance. Further, a plurality of fluorine-containing organic compounds may be used. These terminal groups may be ionized in a solvent. To address defects, present with a different charge such as an iodine defect, a lead defect, and a halogen defect on the surface of the perovskite layer, the fluorine-containing organic compound more preferably has both a terminal group that can be cationized and a terminal group that can be anionized. Examples of the terminal having both a terminal group that can be cationized and a terminal group that can be anionized include a phosphocholine group and a carbamic acid group. Examples of Polymers

Examples of the fluorine-containing organic compound include 4-fluorophenethylamine hydroiodide (FPEAI), 4-(3-fluoromethyl)phenylammonium hydroiodide, 2,6-difluoroaniline, 3,4,5-trifluoroaniline, pentafluorophenylphosphonic acid (5FPAc), pentafluorophenylhydrazine (5FPHZ), and 5-fluorobenzene-amino-carboxylic acid (carbamic acid) hydroiodide as a compound having a benzene skeleton substituted with fluorine and a trifluoromethyl group. When the fluorine-containing organic compound has an alkyl chain skeleton, examples of the fluorine-containing organic compound having a trifluoromethyl group at the tip and a lyophilic terminal include: 1H,1H-undecafluorohexylamine (CF₃(CF₂)₄CH₂NH₂); 1H,1H-pentadecafluorooctylamine (CF₃(CF₂)₆CH₂NH₂); (fluorinated)Fos-Choline-8 (registered trademark: C₁₃H₁₇F₁₃NO₄P); 2,2,2-trifluoroethylamine (CF₃CH₂NH₂); and 3,3,4,4,5,5,6,6-nonafluorohexylphosphonic acid (FHPA), and examples of the fluorine-containing organic compound having a polymer structure include polyvinylidene fluoride (PVDF). When the fluorine-containing organic compound has an alkyl chain skeleton, as a compound having a phenyl group that has fluorine or a trifluoromethyl group, pentafluorophenoxydodecylphosphonic acid (12-pentafluorophenoxydodecylphosphonic acid: C₁₈H₂₆F₅O₄P) can be mentioned. By measuring the contact angle, it is possible to verify that a fluorine-containing organic compound has formed a passivation layer on the surface. For example, when evaluating with chlorobenzene, the contact angles of a linear fluoroalkyl chain, 1H,1H-undecafluorohexylamine, (fluorinated) Fos-Choline-8, and the like, which are highly lyophilic, are increased by addition of a small amount thereof.

The electron transport layer 70 selectively transmits electrons to the second electrode layer 80. The electron transport layer 70 is formed of, for example, a material mainly composed of fullerene or the like. Examples of the fullerene include C60, C70, hydrides, oxides, and metal complexes thereof, and derivatives thereof to which alkyl groups and the like have been added, such as PCBM ([6,6]-phenyl-C61-butyric acid methyl ester). In addition, a hole blocking layer such as bathocuproine (BCP), lithium fluoride (LiF), tin oxide (SnO₂), aluminum-doped zinc oxide (ZnO), or titanium oxide (TiO₂) may be included between the electron transport layer and the second electrode layer. An inorganic oxide layer may dope another metal material.

When the solar cell 1 receives light from a substrate 10 side, the second electrode layer 80 preferably includes a metal layer formed of, for example, copper or the like to reduce electrical resistance. When the solar cell 1 receives light from a second electrode layer 80 side, the second electrode layer 80 may be formed of a transparent conductive oxide.

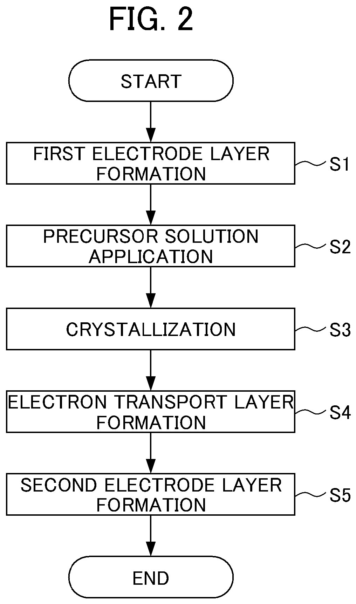

The solar cell 1 having the above configuration is produced by the method for producing a solar cell according to one embodiment of the present invention shown in FIG. 2. The method for producing a solar cell of the present embodiment includes: a first electrode layer forming step (step S1); a precursor solution coating step (step S2), a crystallization step (step S3); an electron transport layer forming step (step S4); and a second electrode forming step (step S5).

In the first electrode layer forming step of step S1, the first electrode layer 20 is formed on one main surface of the substrate 10. The first electrode layer 20 may be laminated by using a vacuum film forming technique such as a sputtering method. In the first electrode layer forming step, it is preferable to modify the surface of the formed first electrode layer 20 to promote the formation of the hole transport layer 30 in the subsequent step. Examples of the method of modifying the surface of the first electrode layer 20 include: hydroxylation of the surface by ultraviolet ray-ozone treatment or ozone water washing; film formation by a vacuum film formation technique, such as a sputtering method using an oxide, for example, nickel oxide, on which a self-assembled film easily grows; film formation by a coating technique of oxide nanoparticles; and a heat treatment of activating the surface and removing impurities so that the self-assembled film easily grows.

In the precursor solution coating step of step S2, the first electrode layer 20 is coated with the perovskite precursor solution. The coating of the perovskite precursor solution can be performed using, for example, a die coater, a bar coater, or the like. The perovskite precursor solution applied in the precursor solution coating step is itself one embodiment of the perovskite precursor solution according to the present invention.

The perovskite precursor solution includes: a solvent; a perovskite precursor that forms a perovskite compound to perform photoelectric conversion; a hole transport layer-forming compound that forms a self-assembled monolayer having hole selective permeability; and a fluorine-containing organic compound. In addition, it is preferable that the perovskite precursor solution further contains a hydrochloride that promotes growth of crystals of the perovskite compound.

As the solvent, for example, a polar aprotic solvent such as DMF, DMSO, NMP, GBL, or acetonitrile is used alone or as a mixture of a plurality of types thereof, and other types of solvents may be included.

As the perovskite precursor, a metal halide BX and AX composed of a halogenated organic compound or a halogenated alkali metal are used at a predetermined ratio. The molar concentration of metal atom B is preferably in excess of 0.5 mol% or more and 10 mol% or less with respect to the sum of the molar concentration of organic compound and the molar concentration of alkali metal. As a result, in the crystallization step, other materials are expelled towards the front and rear interfaces of the perovskite precursor solution, to prevent the other materials from being left in the impurity film 41, which forms between the crystals of the resulting perovskite compound. Consequently, a decrease in the photoelectric conversion efficiency due to residual presence of the other materials can be suppressed.

As the hole transport layer-forming compound, a material that forms a self-assembled monolayer having hole selective permeability is used, as described above. Upon the perovskite precursor solution being applied onto the first electrode layer 20, the hole transport layer-forming compound preferentially self-assembles at the interface with the first electrode layer 20 to form a film (hole transport layer 30). The remaining hole transport layer-forming compound that has formed the film at the interface with the first electrode layer 20 also self-assembles on the surface of the coating film of the perovskite precursor solution (on the side opposite to the first electrode layer 20) to form a film (excess material layer 50). Since it is difficult to accurately grasp the growth state of the hole transport layer-forming compound on the surface of the first electrode layer 20 (TCO), here, the number of hole transport forming compounds per coating area is simply estimated on the assumption that the molecular length is a length of the unit cell (lattice constant) of the monomolecular film, and the concentration is determined so that the number of hole transport layer-forming compounds contained in the coating film is larger than the estimated number. Specifically, the concentration of the hole transport layer-forming compound in the perovskite precursor solution may be 0.1 mmol/L or more and 10 mmol/L or less. The film of the hole transport layer-forming compound formed on the surface of the coating film of the perovskite precursor solution provides a passage for moisture volatilizing from the coating film of the perovskite precursor solution. In other words, because the fluorine-containing organic compound layer is hydrophobic, it prevents water from entering the moisture-sensitive perovskite photoelectric conversion layer, increasing reliability. On the other hand, in the application of the perovskite precursor solution, if only the fluorine-containing compound deposits on the surface, moisture contained in the perovskite precursor solution is prevented from escaping to the outside, which lowers reliability of the perovskite layer. Therefore, the hole transport layer-forming compound, which is less hydrophobic than the fluorine-containing compound, is formed on the surface of the coating film, whereby a water passage is provided, which improves the quality of the photoelectric conversion layer 40. In particular, it is effective when the coating is performed in the atmosphere because it is difficult to avoid inflow of moisture into the perovskite precursor.

The fluorine-containing organic compound aggregates in a film-like form on the surface of the coating film of the perovskite precursor solution due to lyophobicity of fluorine to partially cover the surface of the layer (photoelectric conversion layer 40) of the perovskite compound generated from the perovskite precursor, thereby forming the passivation layer 60 that suppresses recombination of photocarriers (hole and electron) at the interface of the photoelectric conversion layer 40. In addition, the fluorine-containing organic compound inhibits the growth of the film of the hole transport layer-forming compound on the surface of the coating film of the perovskite precursor solution, thereby reliably forming a region where the excess material layer 50 does not exist and the passivation layer 60 exists. The concentration of the fluorine-containing organic compound in the perovskite precursor solution may be 1 µmol/L or more and 5 mmol/L or less. To obtain high performance, it is preferable that the coverage of the surface of the fluorine-containing organic compound is high. More preferably, the fluorine-containing organic compound is formed on substantially the entire surface (for example, in a region of 90% or more), whereby it is possible to suppress the hole transport layer-forming compound from inhibiting electron transport. On the other hand, if the concentration of the fluorine-containing organic compound is increased in order to improve the coverage, the fluorine-containing organic compound is incorporated into the perovskite compound and serves as an impurity, so that recombination is likely to occur. Furthermore, if a plurality of layers is formed, the resistance is increased, and thus the performance may be deteriorated. Therefore, when the fluorine-containing organic compound is a low molecule, the number of fluorine-containing organic compounds per coating area is estimated on the assumption that the molecular length is a length of the unit cell (lattice constant) of the monomolecular film, and the concentration is determined so that the number of fluorine-containing organic compounds contained in the coating film is smaller than the estimated number, as in the case of the hole transport layer-forming compound. Note that the passivation layer 60 and the excess material layer 50 cannot cover the entire surface of the photoelectric conversion layer 40 in some cases. In such cases, the passivation layer may be additionally formed. The additional passivation layer may be formed by a solution of an organic compound or may be formed by vapor deposition of an inorganic material such as lithium fluoride or magnesium difluoride.

Hydrochlorides promote crystallization of the perovskite compound and increase the particle size of the perovskite crystals. As a result, the area of a grain boundary in the photoelectric conversion layer 40 is reduced, suppressing impurities between the perovskite crystals from decreasing the photoelectric conversion efficiency. As the hydrochloride, methylammonium hydrochloride (MACl), formamidinium hydrochloride (FACl), and methylenediaminium hydrochloride (MDACl₂) can be used. With regard to a moiety other than the hydrochloride, the size thereof is equal to or smaller than the crystal lattice of the perovskite crystal, and the moiety preferably has an amino group. The concentration of the hydrochloride in the perovskite precursor solution may be 1 mol% or more and 40 mol% or less with respect to the molar concentration of B-site of the photoelectric conversion layer 40.

In the crystallization step of step S3, the film of the perovskite precursor solution is dried to cause the molecules of the perovskite precursor to react with each other to produce crystals of the perovskite compound. Thus, the photoelectric conversion layer 40 mainly composed of a perovskite compound is formed, and the hole transport layer 30, the excess material layer 50, and the passivation layer 60 are fixed. As crystals of the perovskite compound grow, an impurity film 41 that contains an excess of metal B and a metal compound are formed between crystal grains of the perovskite compound. Since the crystal of the perovskite compound grows from a surface side (a side opposite to the first electrode layer 20), the impurity film 41 also grows from the surface side toward the first electrode layer 20. As a method of promoting the formation of crystals of the perovskite compound in the film of the perovskite precursor solution, for example, poor solvent quenching, vacuum quenching, gas quenching, laser treatment, or the like is preferably employed. In the crystallization step of step S3, the dried coating film of the perovskite precursor solution may be further heated.

In the electron transport layer forming step of step S4, the electron transport layer 70 is formed by, for example, a coating method, a vacuum deposition method, or the like. A hole blocking layer may be formed on the electron transport layer 70 by a vacuum deposition method or an atomic deposition method.

In the second electrode forming step of step S5, the second electrode layer 80 is formed by a method such as a sputtering method, a vacuum evaporation method, a plating method, or a coating method depending on the forming material.

As described above, since the perovskite precursor solution according to one embodiment of the present invention includes the perovskite precursor, the hole transport layer-forming compound, and the fluorine-containing organic compound, while the perovskite precursor solution simultaneously forms the hole transport layer 30 and the photoelectric conversion layer 40 on the first electrode layer 20, the passivation layer 60 is formed on the surface of the photoelectric conversion layer 40 by one coating. Thus, it is possible to prevent the photoelectric conversion layer 40 from being completely covered with the excess material layer 50 that inhibits transmission of electrons. As a result, this method makes it straightforward to manufacture solar cell 1 with relatively high photoelectric conversion efficiency.

Although embodiments of the present invention have been described above, the present invention is not limited to the above-described embodiments, and various modifications and variations are possible. The solar cell may incorporate an additional functional layer, such as a second passivation layer positioned between both the excess material layer and the passivation layer and the electron transport layer. This second passivation layer serves to cover one side of each of the excess material layer and the passivation layer. This second passivation layer may be formed from a material similar to the material of the first passivation layer laminated in the absence region of the excess material layer. In the solar cell according to the present invention, the electron transport layer may be omitted. In addition, in the solar cell according to the present invention, a photoelectric conversion body of the crystalline silicon solar cell may be used as a substrate to form a tandem solar cell.

### EXAMPLES

Hereinafter, the present invention will be specifically described based on Examples, but the present invention is not limited to the following Examples.

### (Example 1)

As a substrate, a commercially available glass/ITO substrate (first electrode) was used. First, a NiOₓ film was formed as an electron blocking layer. Next, a perovskite precursor solution was applied, and a crystallization step and heating were performed to generate crystals of the perovskite compound, thereby a hole transport layer, a photoelectric conversion layer, an excess material layer, and a passivation layer were formed. In the crystallization step, a vacuum quenching method was used. Further, an electron transporting layer was formed by applying PCBM, BCP was formed as a hole blocking layer through vapor deposition, and silver was laminated through vapor deposition to form a second electrode, thereby the solar cell of Example 1 was produced. As the perovskite precursor solution, a solution of 1.2 mol/L of a perovskite precursor (PbI₂, CsI, and FAI), 1.5 mmol/L of Me-4PACz (a hole transport layer-forming compound), and 1.0 mmol/L of 5FPAc (a fluorine-containing organic compound) dissolved in a mixed solvent of DMF and NMP in a volume ratio of 90:10 was used. The perovskite precursor contained FA and Cs at a molar ratio of 90:10 for A-site formation, Pb for B-site formation, and I as a halogen atom for X-site formation.

### (Examples 2 to 5)

The solar cell of Example 2 was produced under the same conditions as in Example 1 except that 1.0 mmol/L of 5FPHZ was used as the fluorine-containing organic compound. The solar cell of Example 3 was produced under the same conditions as in Example 1 except that 0.1 mmol/L of perfluorooctane was used as the fluorine-containing organic compound. The solar cell of Example 4 was produced under the same conditions as in Example 1 except that 0.2 mmol/L of (fluorinated) Fos-Choline-8 was used as the fluorine-containing organic compound. The solar cell of Example 5 was produced under the same conditions as in Example 1 except that 1 µmol/L of PVDF (molecular weight: 180,000) was used as the fluorine-containing organic compound.

### (Examples 6 to 7)

The solar cell of Example 6 was produced under the same conditions as in Example 1 except that PbI₂ in the perovskite precursor solution was altered to an excess of 1 mol%. The solar cell of Example 7 was produced under the same conditions as in Example 1 except that MACl of the perovskite precursor solution was altered to an excess of 15 mol%.

### (Comparative Example 1)

Comparative Example 1 of the solar cell was produced under the same conditions as in Example 1 except that the perovskite precursor solution containing no fluorine-containing organic compound was used.

Photoelectric conversion efficiencies of Examples 1 to 5 and Comparative Example 1 were measured, and ratios thereof to that of Comparative Example 1 were calculated. As a result, as shown in the following Table 1, the ratios were 1.05 for Example 1, 1.01 for Example 2, 1.04 for Example 3, 1.15 for Example 4, 1.10 for Example 5, 1.09 for Example 6, and 1.08 for Example 7. As described above, it was confirmed that the photoelectric conversion efficiency could be improved by blending the hole transport layer-forming compound and the fluorine-containing organic compound to the perovskite precursor solution.

**[Table 1]**

| | Hole transport layer forming compound | Fluorine-containing organic compound | Addition amount (mmol/L) | Excess material | Efficiency ratio |
|---|---|---|---|---|---|
| Comparative Example 1 | | | | | 1 |
| Example 1 | | 5FPAc | 1 | - | 1.05 |
| Example 2 | | 5FPHZ | 1 | - | 1.01 |
| Example 3 | Me4-PACz | Perfluorooctane | 0.1 | - | 1.04 |
| Example 4 | | (Fluorinated) Fos-Choline-8 | 0.2 | - | 1.15 |
| Example 5 | | PVDF | 0.001 | - | 1.1 |
| Example 6 | | 5FPAc | 1 | PbI₂ 1mol% | 1.09 |
| Example 7 | | 5FPAc | 1 | MACI 15mol% | 1.08 |

### (Examples 11 to 30 and Comparative Example 2)

As summarized in the following Table 2, solar cells of Examples 11 to 30 and Comparative Example 2 were prototyped by altering the hole transport layer-forming compound, the fluorine-containing organic compound, and the excess material of the perovskite precursor solution from those of Example 1. Table 2 also shows the ratios of the photoelectric conversion efficiencies of Examples 11 to 20 and Comparative Example 2 to that of Comparative Example 2. Note that in Examples 25 and 27, two types of fluorine-containing organic compounds were blended into the perovskite precursor solution.

**[Table 2]**

| | Hole transport layer forming compound | Fluorine-containing organic compound | Addition amount (mmol/L) | Excess material | Efficiency ratio |
|---|---|---|---|---|---|
| Comparative Example 2 | | - | - | - | 1 |
| Example 11 | | FPEAI | 0.4 | - | 1.08 |
| Example 12 | | CF3-PEAI | 0.3 | - | 1.08 |
| Example 13 | | 2,6-difluoroanilne | 0.4 | - | 1.04 |
| Example 14 | | 3,4,5-trifluoroaniline | 0.7 | - | 1.04 |
| Example 15 | | 5FPHZ | 1.5 | - | 1.01 |
| Example 16 | | 5FPAc | 0.4 | - | 1.09 |
| Example 17 | | 5FPAc | 0.4 | PbI₂ 1mol% | 1.1 |
| Example 18 | | 5FPAc | 0.4 | MACI 15mol% | 1.11 |
| Example 19 | Me-4PACz | Pentafluorobenzene-carbamic acid hydroiodide | 0.2 | - | 1.08 |
| Example 20 | | Pentafluorophenoxydodecylphosphonic acid | 0.7 | - | 1.13 |
| Example 21 | | Pentafluorophenoxydodecylphosphonic acid | 0.2 | - | 1.14 |
| Example 22 | | 2,2,2-trifluoroethylamine | 0.5 | - | 1.03 |
| Example 23 | | FHPA | 0.2 | - | 1.08 |
| Example 24 | | (Fluorinated) Fos-Choline-8 | 0.2 | - | 1.15 |
| Example 25 | | (Fluorinated) Fos-Choline-8 & PVDF | 0.2+0.001 | - | 1.17 |
| Example 26 | | 1H,1H-undecafluorohexylamine | 0.1 | - | 1.11 |
| Example 27 | | 1H,1H-undecafluorohexylamine & (fluorinated) Fos-Choline-8 | 0.1+0.2 | - | 1.12 |
| Example 28 | | 1H,1H-pentadecafluorooctylamine | 0.1 | - | 1.1 |
| Example 29 | | PVDF | 0.001 | - | 1.08 |
| Example 30 | MeO-4PACz | (Fluorinated) Fos-Choline-8 | 0.2 | - | 1.14 |

### (Examples 31 to 40 and Comparative Example 3)

Solar cells of Examples 31 to 40 and Comparative Example 3 were prototyped by including FA and Cs at a molar ratio of 80:20 for forming A-site, Pb for forming B-site, and I and Br at a molar ratio of 90:10 as halogen atoms for forming X-site, and further, as summarized in the following Table 3, by altering the hole transport layer-forming compound, the fluorine-containing organic compound, and the excess material of the perovskite precursor solution from those of Example 1. Table 3 shows the ratios of the photoelectric conversion efficiencies of Examples 31 to 40 and Comparative Example 3 to that Comparative Example 3.

**[Table 3]**

| | Hole transport layer forming compound | Fluorine-containing organic compound | Addition amount (mmol/L) | Excess material | Efficiency ratio |
|---|---|---|---|---|---|
| Comparative Example 3 | Me-4PACz | - | - | - | 1 |
| Example 31 | | FPEAI | 0.4 | - | 1.09 |
| Example 32 | | 5FPAc | 0.2 | - | 1.06 |
| Example 33 | | 5FPAc | 0.6 | - | 1.07 |
| Example 34 | | 5FPAc | 0.2 | MDACI₂ 2mM | 1.1 |
| Example 35 | | 5FPAc | 0.2 | MACI 5mol% | 1.08 |
| Example 36 | | Pentafluorophenoxydodecylphosphonic acid | 0.2 | - | 1.1 |
| Example 37 | | (Fluorinated) Fos-Choline-8 | 0.1 | - | 1.09 |
| Example 38 | | 1H,1H-undecafluorohexylamine | 0.03 | - | 1.04 |
| Example 39 | MeO-4PACz | 5FPAc | 0.2 | - | 1.05 |
| Example 40 | Me-phpPACz | 5FPAc | 0.2 | - | 1.04 |

As described above, it was verified that the photoelectric conversion efficiency can be improved by blending the hole transport layer-forming compound and the fluorine-containing organic compound into various perovskite precursor solutions.

### EXPLANATION OF REFERENCE NUMERALS

1 Solar cell
10 Substrate
20 First electrode layer
30 Hole transport layer
40 Photoelectric conversion layer
41 Impurity film
50 Excess material layer
60 Passivation layer
70 Electron transport layer
80 Second electrode layer

## Claims

1. A perovskite precursor solution comprising:
a solvent;
a perovskite precursor that forms a perovskite compound to perform photoelectric conversion;
a hole transport layer-forming compound that forms a self-assembled monolayer having hole selective permeability; and
a fluorine-containing organic compound.

2. The perovskite solution according to claim 1, wherein the fluorine-containing organic compound has at least one or more of an amino group, a hydrazine group, a trialkylamino group, a phosphocholine group, a phosphoric acid group, a phosphonic acid group, a hydroxy group, a carboxy group, a sulfonyl group, or ionized products thereof at a terminal of the fluorine-containing organic compound.

3. The perovskite solution according to claim 1 or 2, wherein the fluorine-containing organic compound has a carbon skeleton comprising an alkyl chain or benzene in which hydrogen is substituted with fluorine or a trifluoromethyl group.

4. The perovskite solution according to claim 3, wherein the alkyl chain or the benzene continuously comprises carbon to which fluorine is bonded.

5. The perovskite solution according to claim 1 or 2, wherein the fluorine-containing organic compound has a terminal group that can be cationized and a terminal group that can be anionized.

6. The perovskite solution according to claim 1 or 2, comprising a plurality of types of the fluorine-containing organic compounds.

7. The perovskite solution according to claim 1 or 2, wherein the perovskite precursor comprises a metal halide comprising a lead halide and comprises a halogenated organic compound or a halogenated alkali metal, and a molar concentration of the metal is in excess of 0.5 mol% or more and 10 mol% or less with respect to the sum of a molar concentration of the organic compound and a molar concentration of the alkali metal.

8. The perovskite solution according to claim 1 or 2, further comprising a hydrochloride that promotes crystal growth of the perovskite compound.

9. A method for producing a solar cell, comprising:
coating a first electrode layer formed on one main surface of a substrate with the perovskite precursor solution according to claim 1 or 2; and
volatilizing a solvent from a coating film of the perovskite precursor solution and allowing the perovskite precursor to react to produce crystals of a perovskite compound.

10. A solar cell comprising:
a plate-shaped or sheet-shaped substrate;
a first electrode layer laminated on one main surface of the substrate;
a hole transport layer laminated on the first electrode layer, the hole transport layer comprising a film of a hole transport layer-forming compound that has hole selective permeability;
a photoelectric conversion layer laminated on the hole transport layer, the photoelectric conversion layer comprising a perovskite compound;
an excess material layer partially laminated on the photoelectric conversion layer, the excess material layer comprising the hole transport layer-forming compound;
a passivation layer laminated in a region on the photoelectric conversion layer where the excess material layer is absent, the passivation layer comprising a fluorine-containing organic compound; and
a second electrode layer laminated on the excess material layer and the passivation layer.

11. The solar cell according to claim 10, wherein the photoelectric conversion layer has an impurity film comprising a halide of a metal atom included in the perovskite compound, at a grain boundary of a crystal of the perovskite compound.
